# EUROPEAN PATENT SPECIFICATION

(11) **EP 4 470 770 B1**
(45) Date of publication and mention of the grant of the patent: **06.05.2026**
(21) Application number: 23844915.1
(22) Date of filing: 21.04.2023
(51) Int. Cl.: B32B 17/02, B32B 17/04, B32B 17/12, B32B 7/00, B32B 5/04, B32B 5/08, B32B 5/26, B29C 70/20, B29C 70/30, B29C 70/42, B32B 5/12, B32B 5/02, H04M 1/02

(54) **FIBERGLASS BOARD, REAR COVER, ELECTRONIC DEVICE, AND PREPARATION METHOD FOR FIBERGLASS BOARD**
GLASFASERPLATTE, HINTERE ABDECKUNG, ELEKTRONISCHE VORRICHTUNG UND HERSTELLUNGSVERFAHREN FÜR GLASFASERPLATTE
PANNEAU DE FIBRE DE VERRE, COUVERCLE ARRIÈRE, DISPOSITIF ÉLECTRONIQUE ET PROCÉDÉ DE PRÉPARATION D'UN PANNEAU DE FIBRE DE VERRE

(30) Priority: 29.07.2022 CN 202210905853
(43) Date of publication of application: 04.12.2024
(73) Proprietor: Honor Device Co., Ltd., Shenzhen, Guangdong 518040 (CN)
(72) Inventor: SHEN, Kui, Shenzhen, Guangdong 518040 (CN); TAN, Dongsheng, Shenzhen, Guangdong 518040 (CN); LI, Jianping, Shenzhen, Guangdong 518040 (CN)
(74) Representative: Gill Jennings & Every LLP
(86) International application number: PCT/CN2023/089658
(87) International publication number: WO 2024/021699

(56) References cited:
- CN-A- 108 284 619
- CN-A- 110 712 403
- CN-U- 206 465 569
- US-A1- 2016 107 349
- US-A1- 2020 139 642
- US-A1- 2021 339 499

## Description

This application claims priority to Chinese Patent Application No. 202210905853.4, filed with the China National Intellectual Property Administration on July 29, 2022 and entitled "GLASS FIBER BOARD, BACK COVER, ELECTRONIC DEVICE, AND PREPARATION METHOD FOR GLASS FIBER BOARD".

### TECHNICAL FIELD

This application relates to the field of electronic device technologies, and in particular, to a glass fiber board, a back cover, an electronic device, and a preparation method for a glass fiber board.

### BACKGROUND

With continuous development of science and technology, electronic devices such as mobile phones are widely used in people's daily life and work, and have become indispensable daily articles. In a current electronic device, a glass fiber board (also referred to as a fiberglass board) is usually used to prepare a back cover to implement a lightweight design of the electronic device. However, the glass fiber board has poor puncture resistance, which reduces reliability of use of the electronic device. CN 206465569 U discloses a high-strength shear-resistant fiberreinforced laminate structure obtained by laminating at least two layers of fiberglass mesh in turn and thermoforming, and the layers of fiberglass mesh are arranged in a staggered manner. US 2016/0107349 Al discloses a composite sheet, an electronic apparatus and a method for producing a component from composite sheet. US 2021/339499 A1 discloses shock and impact resistant structures. Particularly, it discloses materials having a helicoidal architecture.

### SUMMARY

The present invention is defined by the appended claims. This application provides a glass fiber board, a back cover, an electronic device, and a preparation method for a glass fiber board, to improve puncture resistance of the glass fiber board and improve reliability of use of the electronic device.

According to a first aspect, this application provides a glass fiber board, including a plurality of glass fiber layers, and the plurality of glass fiber layers are disposed in a stacking manner. Each glass fiber layer includes a plurality of first fibers and a plurality of second fibers, and the plurality of first fibers and the plurality of second fibers are disposed in an interlacing manner. Each glass fiber layer has a first direction and a second direction. The plurality of first fibers extend along the first direction of the glass fiber layer and are arranged at intervals along the second direction of the glass fiber layer. The plurality of second fibers extend along the first direction of the glass fiber layer and are arranged at intervals along the first direction of the glass fiber layer.

A helical staggering angle is formed between any two glass fiber layers. A helical staggering angle between two glass fiber layers is an included angle between the first directions of the two glass fiber layers, or a helical staggering angle between two glass fiber layers is an included angle between the second directions of the two glass fiber layers.

A helical staggering angle between at least two glass fiber layers is greater than 0 degrees and less than 90 degrees or is greater than 90 degrees and less than 180 degrees. In other words, at least two glass fiber layers are helically stacked in a staggering manner.

In the glass fiber board shown in this application, at least two glass fiber layers are helically stacked in a staggering manner, and the first fibers and the second fibers of the at least two glass fiber layers are disposed in a staggering manner in a star shape, thereby increasing an inter-layer binding force between the plurality of glass fiber layers. When the glass fiber board is subjected to a puncture force F, the puncture force F may be transmitted along extending directions of the first fibers and the second fibers of the plurality of glass fiber layers. Because at least two glass fiber layers are helically stacked in a staggering manner, the puncture force F may be transmitted along a plurality of directions, so that a force area of the glass fiber board is increased, a stress dispersion effect of the glass fiber board is enhanced, and a synergistic toughening capability inside the glass fiber board is increased, thereby improving puncture resistance of the glass fiber board.

In an implementation, the first direction and the second direction of the glass fiber layer are perpendicular to each other.

In an implementation, the glass fiber layer is formed by weaving the plurality of first fibers and the plurality of second fibers.

In an implementation, the helical staggering angle between any two glass fiber layers is greater than 0 degrees and less than 180 degrees. In other words, the plurality of glass fiber layers are helically stacked in a staggering manner, and the first fibers and the second fibers of any two glass fiber layers are disposed in a staggering manner in a star shape, thereby increasing an inter-layer binding force between the plurality of glass fiber layers. When the glass fiber board is subjected to a puncture force F, the puncture force F may be transmitted along extending directions of the first fibers and the second fibers of the plurality of glass fiber layers. Because the plurality of glass fiber layers are helically stacked in a staggering manner, the puncture force F may be transmitted along a plurality of directions, so that a force area of the glass fiber board is increased, a stress dispersion effect of the glass fiber board is enhanced, and a synergistic toughening capability inside the glass fiber board is increased, thereby improving the puncture resistance of the glass fiber board.

In an implementation, a helical staggering angle between any two glass fiber layers is greater than 0 degrees and less than 90 degrees, so that the first fibers and the second fibers in the plurality of glass fiber layers are radiated in a plurality of directions, which helps improve a stress dispersion effect of the glass fiber board, and further improves the puncture resistance of the glass fiber board.

In an implementation, a helical staggering angle between any two glass fiber layers is greater than 0 degrees and less than or equal to 45 degrees, so that the first fibers and the second fibers in the plurality of glass fiber layers are radiated in a plurality of directions, which helps improve a stress dispersion effect of the glass fiber board, and further improves the puncture resistance of the glass fiber board.

In an implementation, a helical staggering angle between two adjacent glass fiber layers is greater than 0 degrees and less than or equal to 45 degrees, so that the first fibers and the second fibers in the plurality of glass fiber layers are radiated in a plurality of directions, which helps improve a stress dispersion effect of the glass fiber board, and further improves the puncture resistance of the glass fiber board. For example, an included angle between two adjacent glass fiber layers is 20 degrees, 30 degrees, or 45 degrees.

In an implementation, in each glass fiber layer, both the plurality of first fibers and the plurality of second fibers are glass fibers.

The plurality of glass fiber layers include one or more composite glass fiber layers, the plurality of second fibers in each composite glass fiber layer include one or more third fibers, and toughness of the third fiber is greater than toughness of a glass fiber.

In the composite glass fiber layer, the glass fibers are replaced with fibers of better toughness, so that toughness of the composite glass fiber layer can be improved, and puncture resistance of the composite glass fiber layer can be improved, thereby improving the puncture resistance of the glass fiber board.

In an implementation, strength of the third fiber is greater than strength of the glass fiber.

In the composite glass fiber layer, the glass fibers are replaced with fibers of better strength, so that strength of the composite glass fiber layer can be improved, and the puncture resistance of the composite glass fiber layer can be improved, thereby improving the puncture resistance of the glass fiber board.

In an implementation, there are a plurality of third fibers, and the plurality of third fibers are arranged at uniform intervals along a first direction of the composite glass fiber layer, to ensure uniformity of the toughness and the strength of the composite glass fiber layer, and ensure uniformity of the puncture resistance of the composite glass fiber layer, thereby ensuring uniformity of the puncture resistance of the glass fiber board.

In an implementation, the third fiber is an aramid fiber or a carbon fiber.

In an implementation, the plurality of second fibers in each composite glass fiber layer further include one or more fourth fibers, and the fourth fiber is a glass fiber.

In the composite glass fiber layer, some of the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, there are a plurality of third fibers and a plurality of fourth fibers, and the plurality of third fibers and the plurality of fourth fibers are alternately arranged along the first direction of the composite glass fiber layer.

In an implementation, each second fiber in each composite glass fiber layer is a third fiber.

In the composite glass fiber layer, all the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, the plurality of first fibers in each composite glass fiber layer are all glass fibers.

In an implementation, the plurality of first fibers in each composite glass fiber layer include one or more fifth fibers, and toughness of the fifth fiber is greater than the toughness of the glass fiber.

In the composite glass fiber layer, the glass fibers are replaced with fibers of better toughness, so that the toughness of the composite glass fiber layer can be improved, and the puncture resistance of the composite glass fiber layer can be improved, thereby improving the puncture resistance of the glass fiber board.

In an implementation, strength of the fifth fiber is greater than the strength of the glass fiber.

In the composite glass fiber layer, the glass fibers are replaced with fibers of better strength, so that the strength of the composite glass fiber layer can be improved, and the puncture resistance of the composite glass fiber layer can be improved, thereby improving the puncture resistance of the glass fiber board.

In an implementation, there are a plurality of fifth fibers, and the plurality of fifth fibers are arranged at uniform intervals along a second direction of the composite glass fiber layer, to ensure the uniformity of the toughness and the strength of the composite glass fiber layer, and ensure the uniformity of the puncture resistance of the composite glass fiber layer, thereby ensuring the uniformity of the puncture resistance of the glass fiber board.

In an implementation, the fifth fiber is an aramid fiber or a carbon fiber.

In an implementation, the plurality of first fibers in each composite glass fiber layer further include one or more sixth fibers, and the sixth fiber is a glass fiber.

In the composite glass fiber layer, some of the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, each first fiber in each composite glass fiber layer is a fifth fiber.

In the composite glass fiber layer, all the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, there are a plurality of composite glass fiber layers, and the plurality of composite glass fiber layers are uniformly arranged along a thickness direction of the glass fiber layer, to ensure uniformity of toughness and strength of the glass fiber board, and ensure the uniformity of the puncture resistance of the glass fiber board.

In an implementation, each glass fiber layer is a composite glass fiber layer.

According to a second aspect, this application provides a glass fiber board, including a plurality of glass fiber layers that are disposed in a stacking manner, where each glass fiber layer includes a plurality of first fibers and a plurality of second fibers, each glass fiber layer has a first direction and a second direction, the plurality of first fibers extend along the first direction of the glass fiber layer and are arranged at intervals along the second direction of the glass fiber layer, and the plurality of second fibers extend along the first direction of the glass fiber layer and are arranged at intervals along the first direction of the glass fiber layer; and
the plurality of glass fiber layers include one or more composite glass fiber layers, the plurality of second fibers in each composite glass fiber layer include one or more third fibers, and toughness of the third fiber is greater than toughness of a glass fiber.

In the composite glass fiber layer of the glass fiber board shown in this application, glass fibers are replaced with fibers of better toughness, so that toughness of the composite glass fiber layer can be improved, and puncture resistance of the composite glass fiber layer can be improved, thereby improving puncture resistance of the glass fiber board.

In an implementation, the first direction and the second direction are perpendicular to each other.

In an implementation, the glass fiber layer is formed by weaving the plurality of first fibers and the plurality of second fibers.

In an implementation, strength of the third fiber is greater than strength of the glass fiber.

In the composite glass fiber layer, the glass fibers are replaced with fibers of better strength, so that strength of the composite glass fiber layer can be improved, and the puncture resistance of the composite glass fiber layer can be improved, thereby improving the puncture resistance of the glass fiber board.

In an implementation, there are a plurality of third fibers, and the plurality of third fibers are arranged at uniform intervals along a first direction of the composite glass fiber layer, to ensure uniformity of the toughness and the strength of the composite glass fiber layer, and ensure uniformity of the puncture resistance of the composite glass fiber layer, thereby ensuring uniformity of the puncture resistance of the glass fiber board.

In an implementation, the third fiber is an aramid fiber or a carbon fiber.

In an implementation, the plurality of second fibers in each composite glass fiber layer further include one or more fourth fibers, and the fourth fiber is a glass fiber.

In the composite glass fiber layer, some of the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, there are a plurality of third fibers and a plurality of fourth fibers, and the plurality of third fibers and the plurality of fourth fibers are alternately arranged along the first direction of the composite glass fiber layer.

In an implementation, each second fiber in each composite glass fiber layer is a third fiber.

In the composite glass fiber layer, all the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, the plurality of first fibers in each composite glass fiber layer are all glass fibers.

In an implementation, the plurality of first fibers in each composite glass fiber layer include one or more fifth fibers, and toughness of the fifth fiber is greater than the toughness of the glass fiber.

In the composite glass fiber layer, the glass fibers are replaced with fibers of better toughness, so that the toughness of the composite glass fiber layer can be improved, and the puncture resistance of the composite glass fiber layer can be improved, thereby improving the puncture resistance of the glass fiber board.

In an implementation, strength of the fifth fiber is greater than the strength of the glass fiber.

In the composite glass fiber layer, the glass fibers are replaced with fibers of better strength, so that strength of the composite glass fiber layer can be improved, and the puncture resistance of the composite glass fiber layer can be improved, thereby improving the puncture resistance of the glass fiber board.

In an implementation, there are a plurality of fifth fibers, and the plurality of fifth fibers are arranged at uniform intervals along a second direction of the composite glass fiber layer, to ensure the uniformity of the toughness and the strength of the composite glass fiber layer, and ensure the uniformity of the puncture resistance of the composite glass fiber layer, thereby ensuring the uniformity of the puncture resistance of the glass fiber board.

In an implementation, the fifth fiber is an aramid fiber or a carbon fiber.

In an implementation, the plurality of first fibers in each composite glass fiber layer further include one or more sixth fibers, and the sixth fiber is a glass fiber.

In the composite glass fiber layer, some of the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, each first fiber in each composite glass fiber layer is a fifth fiber.

In the composite glass fiber layer, all the glass fibers are replaced with fibers of better toughness and strength, so that the toughness and the strength of the composite glass fiber layer can be improved, and the puncture resistance of the composite glass fiber layer can be improved, thereby improving the puncture resistance of the glass fiber board.

In an implementation, there are a plurality of composite glass fiber layers, and the plurality of composite glass fiber layers are uniformly arranged along a thickness direction of the glass fiber layer, to ensure uniformity of toughness and strength of the glass fiber board, and ensure the uniformity of the puncture resistance of the glass fiber board.

In an implementation, each glass fiber layer is a composite glass fiber layer.

In an implementation, a helical staggering angle of any two glass fiber layers is 0 degrees. In other words, the plurality of glass fiber layers are directly stacked without being helically stacked in a staggering manner.

In an implementation, a helical staggering angle between at least two glass fiber layers is greater than 0 degrees and less than 90 degrees or is greater than 90 degrees and less than 180 degrees. In other words, at least two glass fiber layers are helically stacked in a staggering manner.

In the glass fiber board shown in this application, at least two glass fiber layers are helically stacked in a staggering manner, and the first fibers and the second fibers of the at least two glass fiber layers are disposed in a staggering manner in a star shape, thereby increasing an inter-layer binding force between the plurality of glass fiber layers. When the glass fiber board is subjected to a puncture force F, the puncture force F may be transmitted along extending directions of the first fibers and the second fibers of the plurality of glass fiber layers. Because at least two glass fiber layers are helically stacked in a staggering manner, the puncture force F may be transmitted along a plurality of directions, so that a force area of the glass fiber board is increased, a stress dispersion effect of the glass fiber board is enhanced, and a synergistic toughening capability inside the glass fiber board is increased, thereby improving the puncture resistance of the glass fiber board.

In an implementation, the helical staggering angle between any two glass fiber layers is greater than 0 degrees and less than 180 degrees. In other words, the plurality of glass fiber layers are helically stacked in a staggering manner, and the first fibers and the second fibers of any two glass fiber layers are disposed in a staggering manner in a star shape, thereby increasing an inter-layer binding force between the plurality of glass fiber layers. When the glass fiber board is subjected to a puncture force F, the puncture force F may be transmitted along extending directions of the first fibers and the second fibers of the plurality of glass fiber layers. Because the plurality of glass fiber layers are helically stacked in a staggering manner, the puncture force F may be transmitted along a plurality of directions, so that a force area of the glass fiber board is increased, a stress dispersion effect of the glass fiber board is enhanced, and a synergistic toughening capability inside the glass fiber board is increased, thereby improving the puncture resistance of the glass fiber board.

In an implementation, the helical staggering angle between any two glass fiber layers is greater than 0 degrees and less than 90 degrees, so that the first fibers and the second fibers in the plurality of glass fiber layers are radiated in a plurality of directions, which helps improve a stress dispersion effect of the glass fiber board, and further improves the puncture resistance of the glass fiber board.

In an implementation, the helical staggering angle between any two glass fiber layers is greater than 0 degrees and is less than or equal to 45 degrees, so that the first fibers and the second fibers in the plurality of glass fiber layers are radiated in a plurality of directions, which helps improve the stress dispersion effect of the glass fiber board, and further improves the puncture resistance of the glass fiber board.

In an implementation, a helical staggering angle between two adjacent glass fiber layers is greater than 0 degrees and less than or equal to 45 degrees, to increase distribution density of the first fibers and the second fibers of the plurality of glass fiber layers in the plurality of directions, which helps improve the puncture resistance of the glass fiber board. For example, an included angle between two adjacent glass fiber layers is 20 degrees, 30 degrees, or 45 degrees.

According to a third aspect, this application provides a back cover, including any glass fiber board described above and a decorative layer, where the decorative layer is disposed on a bottom surface of the glass fiber board. The glass fiber board shown in this application has good puncture resistance. Therefore, the back cover also has good puncture resistance. In addition, compared with a back cover made of plastic, the back cover shown in this application is made of the glass fiber board, which can improve strength of the back cover and ensure reliability of use of the back cover.

According to a fourth aspect, this application provides an electronic device, including the back cover described above and a frame, where the back cover is mounted on one side of the frame.

In the electronic device shown in this application, the glass fiber board of the back cover has good puncture resistance. Therefore, the back cover also has good puncture resistance. In addition, compared with a back cover made of plastic, the back cover of the electronic device shown in this application is made of the glass fiber board, which can improve the strength of the back cover, ensure the reliability of use of the back cover, and further ensure reliability of use of the electronic device.

According to a fifth aspect, this application provides a preparation method for a glass fiber board, including:
providing a plurality of glass fiber layers, where each glass fiber layer includes a plurality of first fibers and a plurality of second fibers, each glass fiber layer has a first direction and a second direction, the plurality of first fibers extend along the first direction of the glass fiber layer and are arranged at intervals along the second direction of the glass fiber layer, and the plurality of second fibers extend along the second direction of the glass fiber layer and are arranged at intervals along the first direction of the glass fiber layer;
stacking the plurality of glass fiber layers, where a helical staggering angle between at least two glass fiber layers is greater than 0 degrees and less than 90 degrees or is greater than 90 degrees and less than 180 degrees; and
laminating the plurality of stacked glass fiber layers, to obtain a glass fiber layer.

**In** an implementation, in a process of stacking the plurality of glass fiber layers, a helical staggering angle between any two glass fiber layers is greater than 0 degrees and less than 180 degrees.

**In** an implementation, in the process of stacking the plurality of glass fiber layers, the helical staggering angle between any two glass fiber layers is greater than 0 degrees and less than 90 degrees.

**In** an implementation, in the process of stacking the plurality of glass fiber layers, the helical staggering angle between any two glass fiber layers is greater than 0 degrees and less than or equal to 45 degrees.

**In** an implementation, in the process of stacking the plurality of glass fiber layers, a helical staggering angle between two adjacent glass fiber layers is greater than 0 degrees and less than or equal to 45 degrees.

**In** an implementation, in a process of laminating the plurality of stacked glass fiber layers, the plurality of stacked glass fiber layers are laminated by using a vacuum hot pressing tank.

**In** an implementation, in the process of laminating the plurality of stacked glass fiber layers, a hot pressing temperature is 120 degrees Celsius, a pressure is 1 MPa, and a curing time is between 60 min and 90 min.

According to a sixth aspect, this application provides a preparation method for a glass fiber board, including:
providing a plurality of glass fiber layers, where each glass fiber layer includes a plurality of first fibers and a plurality of second fibers, each glass fiber layer has a first direction and a second direction, the plurality of first fibers extend along the first direction of the glass fiber layer and are arranged at intervals along the second direction of the glass fiber layer, the plurality of second fibers extend along the first direction of the glass fiber layer and are arranged at intervals along the first direction of the glass fiber layer, the plurality of glass fiber layers include one or more composite glass fiber layers, the plurality of second fibers in each composite glass fiber layer include one or more third fibers, and toughness of the third fiber is greater than toughness of a glass fiber;
stacking the plurality of glass fiber layers; and
laminating the plurality of stacked glass fiber layers, to obtain a glass fiber layer.

In an implementation, in a process of stacking the plurality of glass fiber layers, a helical staggering angle between any two glass fiber layers is 0 degrees.

In an implementation, in the process of stacking the plurality of glass fiber layers, a helical staggering angle between at least two glass fiber layers is greater than 0 degrees and less than 90 degrees or is greater than 90 degrees and less than 180 degrees.

In an implementation, in the process of stacking the plurality of glass fiber layers, the helical staggering angle between any two glass fiber layers is greater than 0 degrees and less than 180 degrees.

In an implementation, in the process of stacking the plurality of glass fiber layers, the helical staggering angle between any two glass fiber layers is greater than 0 degrees and less than 90 degrees.

In an implementation, in the process of stacking the plurality of glass fiber layers, the helical staggering angle between any two glass fiber layers is greater than 0 degrees and less than or equal to 45 degrees.

In an implementation, in the process of stacking the plurality of glass fiber layers, a helical staggering angle between two adjacent glass fiber layers is greater than 0 degrees and less than or equal to 45 degrees.

In an implementation, in a process of providing the plurality of glass fiber layers, each glass fiber layer is a composite glass fiber layer.

In an implementation, in a process of laminating the plurality of stacked glass fiber layers, the plurality of stacked glass fiber layers are laminated by using a vacuum hot pressing tank.

In an implementation, in the process of laminating the plurality of stacked glass fiber layers, a hot pressing temperature is 120 degrees Celsius, a pressure is 1 MPa, and a curing time is between 60 min and 90 min.

### BRIEF DESCRIPTION OF DRAWINGS

To describe technical solutions in embodiments of this application more clearly, the following describes accompanying drawings required in embodiments of this application.
FIG. 1 is a schematic diagram of a structure of an electronic device according to an embodiment of this application;
FIG. 2 is a schematic diagram of a structure of a back cover in the electronic device shown in FIG. 1;
FIG. 3 is a schematic diagram of a cross-sectional structure of the back cover shown in FIG. 2 cut along I-I;
FIG. 4 is a schematic diagram of a plane structure of a glass fiber board in the back cover shown in FIG. 3 in a first implementation;
FIG. 5 is a schematic diagram of a plane structure of a glass fiber layer in the glass fiber board shown in FIG. 4;
FIG. 6 is a schematic diagram of a plane structure of a first glass fiber layer in the glass fiber board shown in FIG. 4;
FIG. 7 is a schematic diagram of a plane structure of a second glass fiber layer in the glass fiber board shown in FIG. 4;
FIG. 8 is a schematic diagram of a plane structure of a third glass fiber layer in the glass fiber board shown in FIG. 4;
FIG. 9 is a schematic diagram of a plane structure of a fourth glass fiber layer in the glass fiber board shown in FIG. 4;
FIG. 10 is a diagram of force analysis of the glass fiber board shown in FIG. 4;
FIG. 11 is a schematic diagram of a structure of a glass fiber board in the back cover shown in FIG. 3 in a second implementation;
FIG. 12 is a schematic diagram of a plane structure of a glass fiber layer in the glass fiber board shown in FIG. 11;
FIG. 13 is a schematic diagram of a structure of a glass fiber board in the back cover shown in FIG. 3 in a third implementation;
FIG. 14 is a schematic diagram of a plane structure of a glass fiber layer in the glass fiber board shown in FIG. 13;
FIG. 15 is a schematic diagram of a plane structure of a glass fiber board in the back cover shown in FIG. 3 in a fourth implementation; and
FIG. 16 is a process flowchart of a first preparation method for a glass fiber board according to an embodiment of this application.

### DESCRIPTION OF EMBODIMENTS

The following clearly and completely describes technical solutions in embodiments of this application with reference to the accompanying drawings in the embodiments of this application.

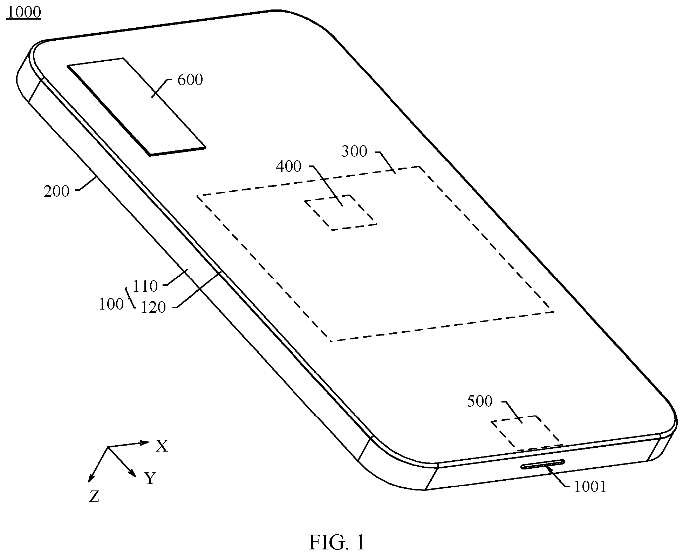

Refer to FIG. 1. FIG. 1 is a schematic diagram of a structure of an electronic device 1000 according to an embodiment of this application.

The electronic device 1000 may be an electronic product such as a mobile phone, a tablet computer, a notebook computer, an infotainment system, a smartwatch, a smart band, or a POS machine (point of sales terminal, point of sales terminal). Next, an example in which the electronic device 1000 is a mobile phone is used for description in this embodiment of this application. For ease of description, a width direction of the electronic device 1000 is defined as an X-axis direction, a length direction of the electronic device 1000 is defined as a Y-axis direction, a thickness direction of the electronic device 1000 is defined as a Z-axis direction, and the X-axis direction, the Y-axis direction, and the Z-axis direction are perpendicular to each other.

The electronic device 1000 includes a housing 100, a display module 200, a circuit board 300, a processor 400, a speaker module 500, and a camera module 600. The housing 100 is provided with a speaker hole 1001, and the speaker hole 1001 is in communication with an inner side and an outer side of the housing 100. The display module 200 is mounted in the housing 100. The circuit board 300, the processor 400, and the speaker module 500 are all mounted on the inner side of the housing 100. The processor 400 is mounted on the circuit board 300, and is electrically connected to the circuit board 300. The circuit board 300 may be a main board (main board) of the electronic device 1000, and the processor 400 may be a CPU (central processing unit, central processing unit) of the electronic device 1000. The speaker module 500 is electrically connected to the processor 400, and is configured to receive an audio signal sent by the processor 400, and vibrate to produce sound based on the audio signal, so that the sound is diffused into an external environment through the speaker hole 1001, to implement sound production of the electronic device 1000. The camera module 600 is mounted in the housing 100, and is exposed relative to the housing 100. The camera module 600 is electrically connected to the processor 400, and is configured to receive an information collection signal sent by the processor 400, collect light outside the electronic device 1000, and form corresponding image data.

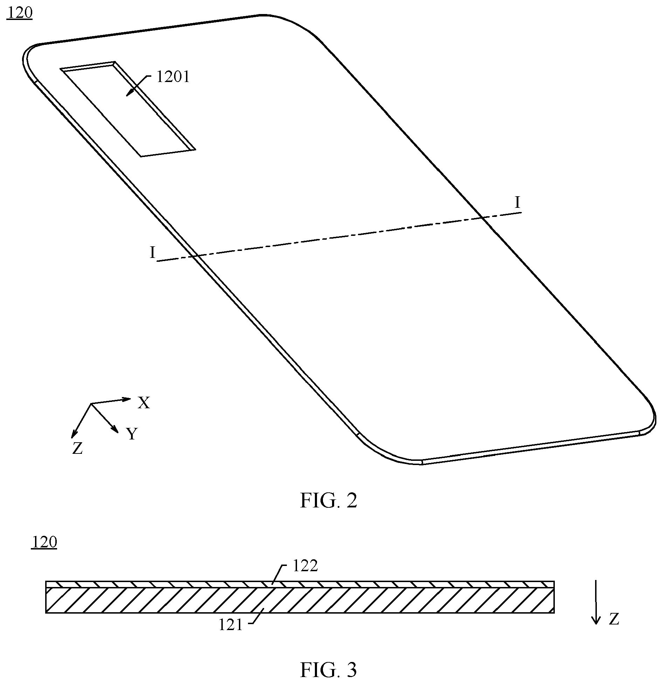

Refer to FIG. 2 as well. FIG. 2 is a schematic diagram of a structure of a back cover 120 in the electronic device 1000 shown in FIG. 1.

The housing 100 includes a frame 110 and the back cover 120. The back cover 120 is mounted on one side of the frame 110. The frame 110 is provided with the speaker hole 1001. For example, there is one speaker hole 1001. In some other embodiments, there may alternatively be at least two speaker holes 1001. A quantity of the speaker holes 1001 is not specifically limited in this application. The back cover 120 may be a battery cover of the electronic device 1000. The back cover 120 is provided with a camera hole 1201, and the camera hole 1201 penetrates through the back cover 120 along a thickness direction of the back cover 120. Specifically, the back cover 120 is mounted on one side of the frame 110. The camera hole 1201 is in communication with the inner side and outer side of the housing 100. For example, the back cover 120 may be mounted in the frame 110 in a detachable manner, to facilitate maintenance and replacement of an internal component or module of the electronic device 1000.

The display module 200 is mounted on the other side of the frame 110. That is, the display module 200 is mounted on a side that is of the frame 110 and that is away from the back cover 120. That is, the display module 200 and the back cover 120 are mounted on opposite sides of the frame 110 respectively. When a user uses the electronic device 1000, the display module 200 is placed toward the user, and the back cover 120 is placed away from the user. A display may be a display such as an LCD (liquid crystal display, liquid crystal display) or an OLED (organic light-emitting diode, organic light-emitting diode), and is configured to display information such as an image or a text.

In this embodiment, the camera module 600 is exposed relative to the back cover 120, to serve as a rear camera module of the electronic device 1000. Specifically, the camera module 600 passes through the camera hole 1201 of the back cover 120. A part of the camera module 600 is located on the inner side of the housing 100, a part of the camera module 600 is located in the camera hole 1201, and a part of the camera module 600 protrudes relative to the back cover 120. It should be noted that the exposure of the camera module 600 relative to the back cover 120 indicates that the back cover 120 does not completely cover the camera module 600. In some other embodiments, the camera module 600 may not protrude relative to the back cover 120. In this case, the camera module 600 may not pass through the camera hole 1201 of the back cover 120, a part of the camera module 600 is located on the inner side of the housing 100, and a part of the camera module 600 is located on the camera hole 1201, or the entire camera module 600 is accommodated on the inner side of the housing 100.

It should be noted that in an existing electronic device, the back cover is usually made of a glass fiber board, to improve strength of the back cover and ensure reliability of use of the back cover. The glass fiber board is formed by stacking and hot pressing a plurality of glass fiber layers (also referred to as a fiberglass layer). The plurality of glass fiber layers are directly stacked without staggering, and an inter-layer binding force between the plurality of glass fiber layers is poor. When the glass fiber board is subjected to a puncture force, the puncture force can only be diffused along orthogonal directions of glass fibers (fiberglass) in the glass fiber layers. Because the inter-layer binding force between the plurality of glass fiber layers is poor and a force area of the glass fiber board is small, a stress dispersion effect of the glass fiber board is poor. Therefore, puncture resistance of the glass fiber board is poor. It should be understood that a puncture value of an existing glass fiber board formed by stacking four glass fiber layers is about 70 N.

Next, the structure of the back cover 120 of the electronic device 1000 shown in this embodiment of this application is specifically described.

Refer to FIG. 3. FIG. 3 is a schematic diagram of a cross-sectional structure of the back cover 120 shown in FIG. 2 cut along I-I. "Cut along I-I" means cutting along a plane on which the I-I line is located.

The back cover 120 includes a glass fiber board 121 and a decorative layer 122. The decorative layer 122 is disposed on a bottom surface of the glass fiber board 121. A surface of the decorative layer 122 (that is, a bottom surface of the decorative layer 122), that faces away from the glass fiber board 121, is an appearance surface of the back cover 120. For example, the decorative layer 122 may include an ink layer or a texture layer. The decorative layer 122 is configured to decorate the appearance of the back cover 120, to improve appearance refinement of the back cover 120.

It should be noted that orientation words such as "top" and "bottom" in this application are described with reference to orientations shown in the accompanying drawings. Using a positive direction toward the Z-axis as the "bottom" and a negative direction toward the Z-axis as the "top" does not indicate or imply that a referred apparatus or component must have a specific orientation or be constructed and operated in a specific orientation, and should not be understood as a limitation on this application.

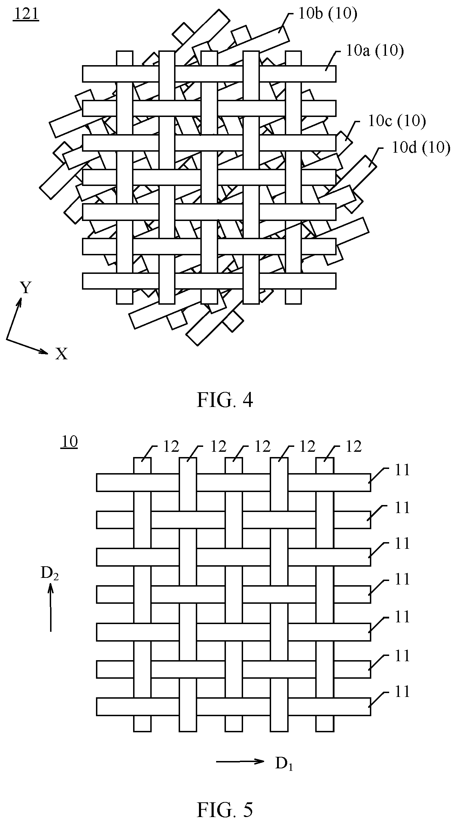

Refer to FIG. 4 and FIG. 5. FIG. 4 is a schematic diagram of a plane structure of a glass fiber board 121 in the back cover 120 shown in FIG. 3 in a first implementation. FIG. 5 is a schematic diagram of a plane structure of a glass fiber layer 10 in the glass fiber board 121 shown in FIG. 4. The plane structure shown in FIG. 4 is a partially enlarged view of the plane structure of the glass fiber board 121.

The glass fiber board 121 includes a plurality to glass fiber layers 10, and the plurality of glass fiber layers 10 are disposed in a stacking manner. A plurality of layers refer to two or more layers. Each glass fiber layer 10 includes a plurality of first fibers 11 and a plurality of second fibers 12, and the plurality of first fibers 11 and the plurality of second fibers 12 are disposed in an interlacing manner. The plurality of first fibers 11 and the plurality of second fibers 12 may form the glass fiber layer 10 through a weaving process. Both the first fibers 11 and the second fibers 12 are glass fibers. For example, grammage of each glass fiber layer 10 is greater than or equal to 100 g/m². In some other embodiments, the grammage of each glass fiber layer 10 may alternatively be less than 100 g/m².

It should be noted that the glass fiber layers 10 described in this embodiment of this application are all glass fiber layers on which a resin impregnation process is performed, and a resin type and a resin content that are used in the resin impregnation process are not specifically limited in this application.

Each glass fiber layer 10 has a first direction D₁ and a second direction D₂. The plurality of first fibers 11 extend along the first direction D₁ and are arranged at intervals with each other along the second direction D₂. The plurality of second fibers 12 extend along the second direction D₂ and are arranged at intervals with each other along the first direction D₁. For example, the first direction D₁ and the second direction D₂ are perpendicular to each other. In some other embodiments, the first direction D₁ and the second direction D₂ may not be perpendicular to each other.

It should be noted that qualifiers such as parallel and perpendicular for a relative position relationship in this embodiment of this application are all for a current process level, and are not absolutely strict definitions in the mathematical sense, a slight deviation is allowed, and approximately perpendicular is acceptable. For example, "A is perpendicular to B" means that A is perpendicular to B or approximately perpendicular to B, and an included angle between A and B is between 80 degrees and 100 degrees. For example, "A is parallel to B" means that A is parallel to B or approximately parallel to B, and an included angle between A and B is between 0 degrees and 10 degrees.

In addition, a helical staggering angle is formed between any two glass fiber layers 10. It should be noted that a helical staggering angle between two glass fiber layers 10 is an included angle between the first directions D₁ of the two glass fiber layers 10, or an included angle between the second directions D₂ of the two glass fiber layers 10. A helical staggering angle between at least two glass fiber layers 10 is greater than 0 degrees and less than 90 degrees or is greater than 90 degrees and less than 180 degrees. In other words, at least two glass fiber layers 10 in the glass fiber board 121 are helically stacked in a staggering manner.

In this implementation, the helical staggering angle between any two glass fiber layers 10 is greater than 0 degrees and less than 180 degrees. In other words, the plurality of glass fiber layers 10 are helically stacked in a staggering manner. Specifically, a helical staggering angle between two adjacent glass fiber layers 10 is greater than 0 degrees and less than or equal to 45 degrees. In some other implementations, the helical staggering angle between any two glass fiber layers 10 may be greater than 0 degrees and less than 90 degrees, or the helical staggering angle between any two glass fiber layers 10 may be greater than 0 degrees and less than or equal to 45 degrees.

Next, for ease of description, a structure of the glass fiber board 121 is specifically described by using four glass fiber layers 10 in the glass fiber board 121 as an example. The four glass fiber layers 10 are respectively a first glass fiber layer 10a, a second glass fiber layer 10b, a third glass fiber layer 10c, and a fourth glass fiber layer 10d. The second glass fiber layer 10b, the third glass fiber layer 10c, and the fourth glass fiber layer 10d are sequentially laminated on a surface of the first glass fiber layer 10a.

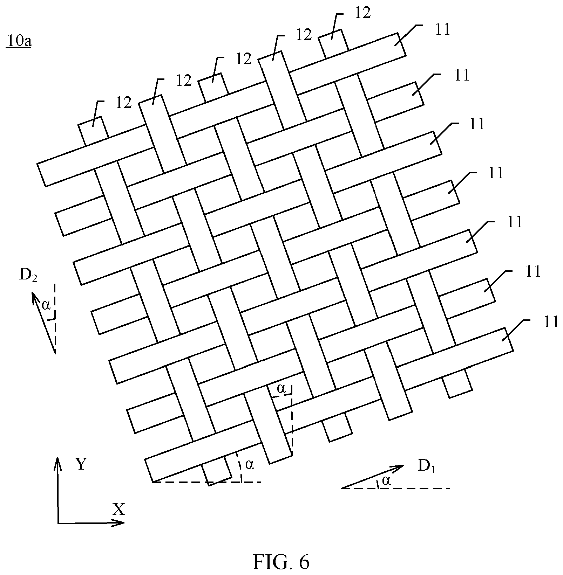

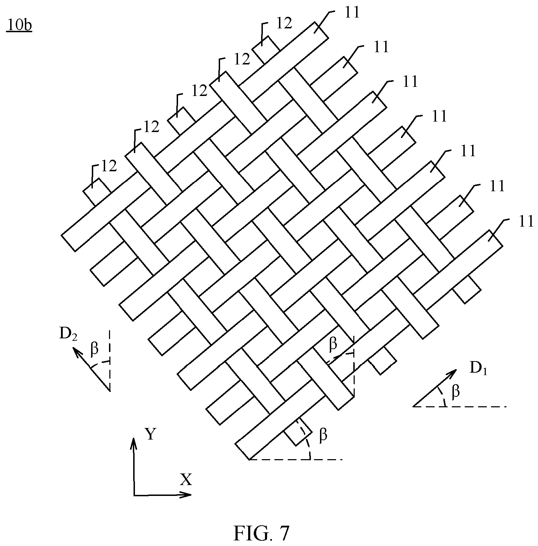

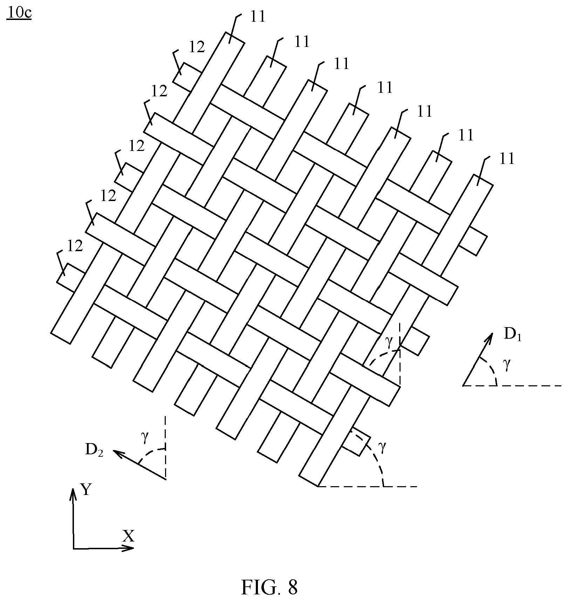

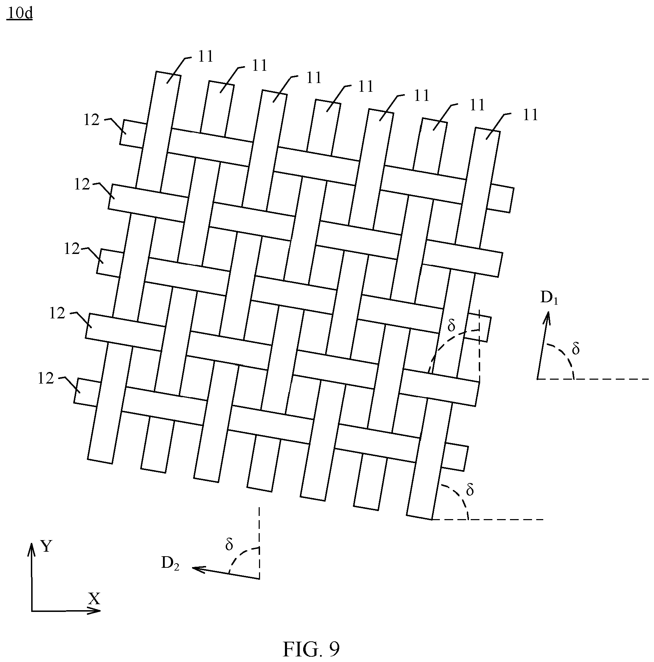

Refer to FIG. 6 to FIG. 9. FIG. 6 is a schematic diagram of a plane structure of the first glass fiber layer 10a in the glass fiber board 121 shown in FIG. 4. FIG. 7 is a schematic diagram of a plane structure of the second glass fiber layer 10b in the glass fiber board 121 shown in FIG. 4. FIG. 8 is a schematic diagram of a plane structure of the third glass fiber layer 10c in the glass fiber board 121 shown in FIG. 4. FIG. 9 is a schematic diagram of a plane structure of the fourth glass fiber layer 10d in the glass fiber board 121 shown in FIG. 4.

In the first glass fiber layer 10a, an included angle between the first direction D₁ and an X-axis direction is α, and an included angle between the second direction D₂ and a Y-axis direction is α. That is, in the first glass fiber layer 10a, an included angle between the first fiber 11 and the X-axis direction is α, and an included angle between the second fiber 12 and the Y-axis direction is α.

It should be noted that, in a preparation process of the glass fiber board 121, when the glass fiber layer 10 is not stacked, in the glass fiber layer 10, the first direction D₁ is parallel to the X-axis direction, and the second direction D₂ is parallel to the Y-axis direction. That is, when each glass fiber layer 10 is not stacked, the included angle between the first fiber 11 and the X-axis direction is 0 degrees, and the included angle between the second fiber 12 and the Y-axis direction is 0 degrees. In some other embodiments, when the glass fiber layer 10 is not stacked, the first direction D₁ may not be parallel to the X-axis direction, or the second direction D₂ may not be parallel to the Y-axis direction.

Therefore, when the first glass fiber layer 10a is stacked, the first glass fiber layer 10a may first be rotated by α degrees in a counterclockwise direction, and then the first glass fiber layer 10a is stacked.

In the second glass fiber layer 10b, the included angle between the first direction D₁ and the X-axis direction is β, and the included angle between the second direction D₂ and the Y-axis direction is β. That is, in the second glass fiber layer 10b, the included angle between the first fiber 11 and the X-axis direction is β, and the included angle between the second fiber 12 and the Y-axis direction is β. In this case, a helical staggering angle between the first glass fiber layer 10a and the second glass fiber layer 10b is β-α.

Similarly, when the second glass fiber layer 10b is stacked on the surface of the first glass fiber layer 10a, the second glass fiber layer 10b may first be rotated by β degrees in the counterclockwise direction, and then the second glass fiber layer 10b is stacked on the surface of the first glass fiber layer 10a, so that the helical staggering angle between the first glass fiber layer 10a and the second glass fiber layer 10b is β-α.

In the third glass fiber layer 10c, the included angle between the first direction D₁ and the X-axis direction is γ, and the included angle between the second direction D₂ and the Y-axis direction is γ. That is, in the third glass fiber layer 10c, the included angle between the first fiber 11 and the X-axis direction is γ, and the included angle between the second fiber 12 and the Y-axis direction is γ. In this case, a helical staggering angle between the second glass fiber layer 10b and the third glass fiber layer 10c is γ-β.

Similarly, when the third glass fiber layer 10c is stacked on a surface that is of the second glass fiber layer 10b and that faces away from the first glass fiber layer 10a, the third glass fiber layer 10c may first be rotated by γ degrees in the counterclockwise direction, and then the third glass fiber layer 10c is stacked on the surface that is of the second glass fiber layer 10b and that faces away from the first glass fiber layer 10a, so that the helical staggering angle between the third glass fiber layer 10c and the second glass fiber layer 10b is γ-β.

In the fourth glass fiber layer 10d, the included angle between the first direction D₁ and the X-axis direction is δ, and the included angle between the second direction D₂ and the Y-axis direction is δ. That is, in the fourth glass fiber layer 10d, the included angle between the first fiber 11 and the X-axis direction is δ, and the included angle between the second fiber 12 and the Y-axis direction is δ. In this case, a helical staggering angle between the third glass fiber layer 10c and the fourth glass fiber layer 10d is δ-γ.

Similarly, when the fourth glass fiber layer 10d is stacked on a surface that is of the third glass fiber layer 10c and that faces away from the second glass fiber layer 10b, the fourth glass fiber layer 10d may first be rotated by δ degrees in the counterclockwise direction, and then the fourth glass fiber layer 10d is stacked on the surface that is of the third glass fiber layer 10c and that faces away from the second glass fiber layer 10b, so that the helical staggering angle between the fourth glass fiber layer 10d and the third glass fiber layer 10c is δ-γ.

In this implementation, a helical staggering angle between adjacent glass fiber layers 10 is greater than 0 degrees and less than or equal to 45 degrees, so that the first fibers 11 and the second fibers 12 in the plurality of glass fiber layers 10 are radiated in a plurality of directions, thereby improving a stress dispersion effect of the glass fiber board 121. For example, the helical staggering angle between adjacent glass fiber layers 10 is 20 degrees. For example, α=20 degrees, β=40 degrees, γ=60 degrees, and δ=80 degrees. In this case, β-α=γ-β=δ-γ=20 degrees. In other words, the helical staggering angle between the second glass fiber layer 10b and the first glass fiber layer 10a, the helical staggering angle between the third glass fiber layer 10c and the second glass fiber layer 10b, and the helical staggering angle between the fourth glass fiber layer 10d and the third glass fiber layer 10c are all 20 degrees. A helical staggering angle between the third glass fiber layer 10c and the first glass fiber layer 10a is 40 degrees, a helical staggering angle between the fourth glass fiber layer 10d and the first glass fiber layer 10a is 60 degrees, and a helical staggering angle between the fourth glass fiber layer 10d and the second glass fiber layer 10b is 40 degrees.

In some other embodiments, the helical staggering angle between adjacent glass fiber layers 10 may alternatively be 30 degrees, for example, α=30 degrees, β=60 degrees, γ=90 degrees, and δ=120 degrees. In this case, β-α=γ-β=δ-γ=30 degrees. Alternatively, the helical staggering angle between adjacent glass fiber layers 10 may be 45 degrees, for example, α=45 degrees, β=90 degrees, γ=135 degrees, and δ=180 degrees. In this case, β-α=γ-β=δ-γ=45 degrees.

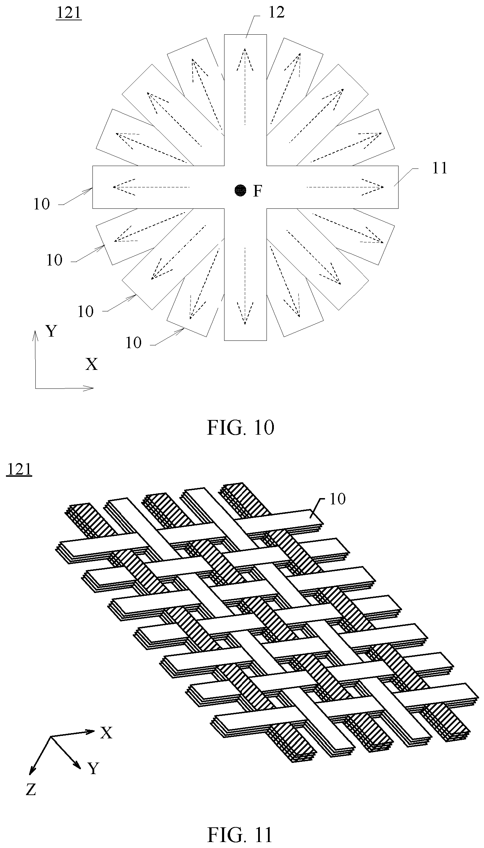

Refer to FIG. 10. FIG. 10 is a diagram of force analysis of the glass fiber board 121 shown in FIG. 4. A dashed line with an arrow shown in FIG. 9 is a transmission direction of a puncture force F.

In the glass fiber board 121 shown in this implementation, the helical staggering angle between two adjacent glass fiber layers 10 is greater than 0 degrees and is less than or equal to 45 degrees, the plurality of glass fiber layers 10 are helically stacked in a staggering manner, and the first fibers 11 and the second fibers 12 of the plurality of glass fiber layers 10 are disposed in a staggering manner in a star shape. That is, in the plurality of glass fiber layers 10, the first fibers 11 do not extend along the X-axis direction, and the second fibers 12 do not extend along the Y-axis direction. The plurality of glass fiber layers 10 are helically stacked in a staggering manner, thereby increasing an inter-layer binding force between the plurality of glass fiber layers 10. When the glass fiber board 121 is subjected to the puncture force F, the puncture force F may be transmitted along extending directions of the first fibers 11 and the second fibers 12 of the plurality of glass fiber layers 10. Because the plurality of glass fiber layers 10 are helically stacked in a staggering manner, the puncture force F may not only be transmitted along the X-axis direction and the Y-axis direction, but also be transmitted along another direction.

That is, compared with an existing glass fiber board, the puncture force F may be transmitted along a plurality of directions, so that a force area of the glass fiber board 121 is increased, a stress dispersion effect of the glass fiber board 121 is enhanced, and a synergistic toughening capability inside the glass fiber board 121 is increased, thereby improving puncture resistance of the glass fiber board 121, and helping implement a lightweight design of the electronic device 1000. A puncture value of the glass fiber board 121 is between 80 N and 85 N. Compared with the existing glass fiber board, the puncture resistance of the glass fiber board 121 shown in this implementation may be improved by at least 14%.

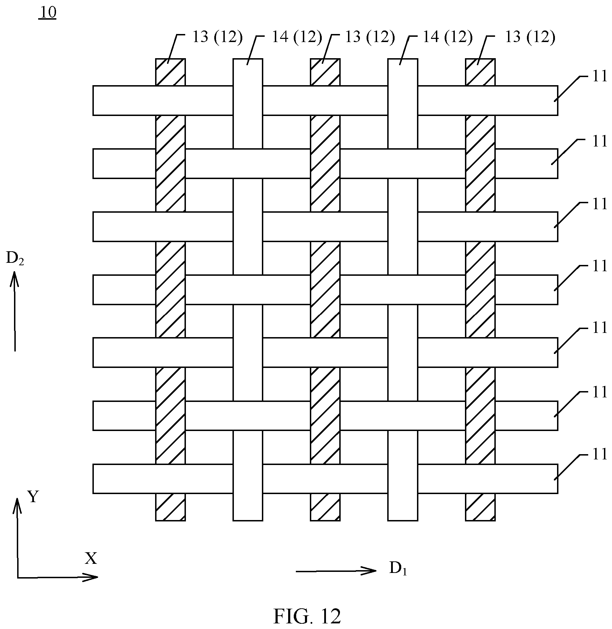

Refer to FIG. 11 and FIG. 12. FIG. 11 is a schematic diagram of a structure of the glass fiber board 121 shown in FIG. 3 in a second implementation. FIG. 12 is a schematic diagram of a plane structure of a glass fiber layer 10 in the glass fiber board 121 shown in FIG. 11. The structure shown in FIG. 11 is a partially enlarged view of a structure of the glass fiber board 121.

A difference between the glass fiber board 121 shown in this implementation and the glass fiber board 121 shown in the first implementation described above is that a helical staggering angle between any two glass fiber layers 10 is 0 degrees. In other words, a plurality of glass fiber layers 10 of the glass fiber board 121 are directly stacked without staggering. It should be noted that FIG. 11 shows only four glass fiber layers 10 of the glass fiber board 121, which does not form a limitation on an actual quantity of the glass fiber layers 10 in the glass fiber board 121.

For example, in each glass fiber layer 10, a first direction D₁ is parallel to an X-axis direction, and a second direction D₂ is parallel to a Y-axis direction. That is, in each glass fiber layer 10, an included angle between a first fiber 11 and the X-axis direction is 0 degrees, and an included angle between a second fiber 12 and the Y-axis direction is 0 degrees. In some other implementations, in each glass fiber layer 10, the first direction D₁ may not be parallel to the X-axis direction, or the second direction D₂ may not be parallel to the Y-axis direction.

In this implementation, the plurality of glass fiber layers 10 include one or more composite glass fiber layers. Specifically, the plurality of glass fiber layers 10 are all composite glass fiber layers. In each composite glass fiber layer 10, a plurality of first fibers 11 are all glass fibers. A plurality of second fibers 12 include a plurality of third fibers 13 and a plurality of fourth fibers 14. The plurality of fourth fibers 14 are all glass fibers. Toughness of the third fiber 13 is greater than toughness of the glass fiber, and strength of the third fiber 13 is greater than strength of the glass fiber. For example, the third fiber 13 is an aramid fiber or a carbon fiber.

The plurality of third fibers 13 are arranged at uniform intervals along the first direction D₁, to ensure uniformity of toughness and strength of the glass fiber layer 10, and ensure uniformity of puncture resistance of the glass fiber layer 10, thereby ensuring uniformity of puncture resistance of the glass fiber board 121. For example, the plurality of third fibers 13 and the plurality of fourth fibers 14 are arranged alternately along the first direction D₁. In some other implementations, the plurality of third fibers 13 may alternatively be arranged at non-uniform intervals along the first direction D₁, or the plurality of second fibers 12 may alternatively include only one third fiber 13.

In some other implementations, the plurality of first fibers 11 may alternatively include a plurality of fifth fibers and one or more sixth fibers. The sixth fiber is a glass fiber. Toughness of the fifth fiber is greater than the toughness of the glass fiber, and strength of the fifth fiber is greater than the strength of the glass fiber. For example, the sixth fiber is an aramid fiber or a carbon fiber. In this case, the plurality of fifth fibers are arranged at uniform intervals along the second direction D₂. Alternatively, the plurality of first fibers 11 may include one fifth fiber, or the plurality of first fibers 11 may be all fifth fibers.

Compared with an existing glass fiber board, in the glass fiber board 121 shown in this implementation, the plurality of second fibers 12 of the glass fiber layer 10 are partially replaced with third fibers 13 with better toughness and strength, so that strength and toughness of the glass fiber layer 10 can be improved, thereby improving strength and toughness of the glass fiber board 121, and improving the puncture resistance of the glass fiber board 121. A puncture value of the glass fiber board 121 is between 80 N and 100 N. Compared with the existing glass fiber board, the puncture resistance of the glass fiber board 121 shown in this implementation may be improved by at least 14%.

In some other implementations, the plurality of glass fiber layers 10 may include one composite glass fiber layer, or the plurality of glass fiber layers 10 include a plurality of composite glass fiber layers and one or more common glass fiber layers. In the common glass fiber layer, the plurality of first fibers 11 and the plurality of second fibers 12 are all glass fibers, and the plurality of composite glass fiber layers are uniformly arranged along a thickness direction of the glass fiber board 121, to ensure uniformity of toughness and strength of the glass fiber board 121, and ensure uniformity of puncture resistance of the glass fiber board 121. Alternatively, the plurality of composite glass fiber layers may be non-uniformly arranged along the thickness direction of the glass fiber board 121.

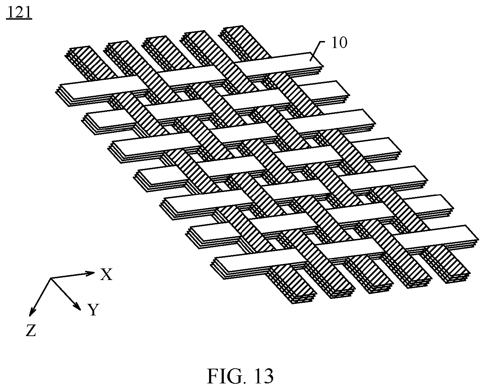

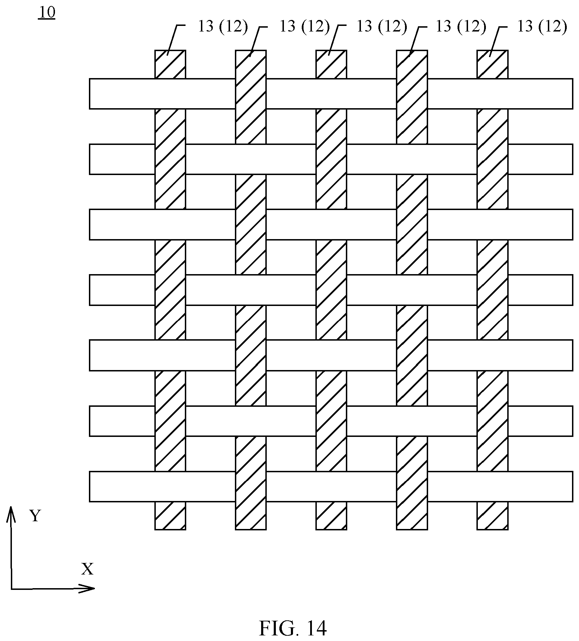

Refer to FIG. 13 and FIG. 14. FIG. 13 is a schematic diagram of a structure of the glass fiber board 121 shown in FIG. 3 in a third implementation. FIG. 14 is a schematic diagram of a plane structure of the glass fiber layer 10 in the glass fiber board 121 shown in FIG. 13. The structure shown in FIG. 13 is a partially enlarged view of a structure of the glass fiber board 121.

A difference between the glass fiber board 121 shown in this implementation and the glass fiber board 121 shown in the second implementation described above lies in that in each glass fiber layer 10, the plurality of second fibers 12 are all third fibers 13, that is, the second fibers 12 are aramid fibers or carbon fibers, to further enhance the toughness and strength of the glass fiber layer 10, thereby enhancing the toughness and strength of the glass fiber board 121, and improving the puncture resistance of the glass fiber board 121. It should be noted that for another structure of the glass fiber board 121 shown in this implementation, references may be made to corresponding descriptions of the glass fiber board 121 shown in the second implementation described above, and details are not described herein again.

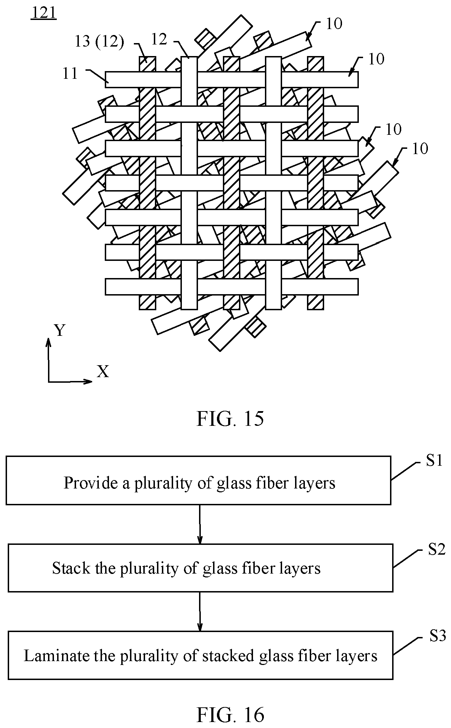

Refer to FIG. 15. FIG. 15 is a schematic diagram of a plane structure of the glass fiber board 121 shown in FIG. 3 in a fourth implementation. The plane structure shown in FIG. 15 is a partially enlarged view of the plane structure of the glass fiber board 121.

A difference between the glass fiber board 121 shown in this implementation and the glass fiber board 121 shown in the second implementation described above is that a helical staggering angle between at least two glass fiber layers 10 is greater than 0 degrees and less than 90 degrees, or is greater than 90 degrees and less than 180 degrees. In other words, at least two glass fiber layers 10 in the glass fiber board 121 are helically stacked in a staggering manner. It should be noted that for a structure of a composite glass fiber layer in the glass fiber board 121 shown in this implementation, reference may be made to related descriptions of the second implementation described above. For a structure of a helical staggering angle between two glass fiber layers 10 in the glass fiber board 121, reference may be made to related descriptions of the first implementation described above, and details are not described herein again.

Compared with an existing glass fiber board, in the glass fiber board 121 shown in this implementation, the plurality of second fibers 12 of the glass fiber layer 10 are partially replaced with third fibers 13 with better toughness and strength, so that strength and toughness of the glass fiber layer 10 can be improved, thereby improving strength and toughness of the glass fiber board 121, and improving the puncture resistance of the glass fiber board 121. In addition, at least two glass fiber layers 10 are helically stacked in a staggering manner, and the first fibers 11 and the second fibers 12 of the at least two glass fiber layers 10 are disposed in a staggering manner in a star shape, thereby increasing an inter-layer binding force between the plurality of glass fiber layers 10.

As shown in FIG. 10, when the glass fiber board 121 is subjected to a puncture force F, the puncture force F may be transmitted along extending directions of the first fibers 11 and the second fibers 12 of the plurality of glass fiber layers 10. Because the at least two the glass fiber layers 10 are helically stacked in a staggering manner, the puncture force F may not only be transmitted along an X-axis direction and a Y-axis direction, but also be transmitted along another direction. That is, compared with the existing glass fiber board, the puncture force F may be transmitted along a plurality of directions, so that a force area of the glass fiber board 121 is increased, a stress dispersion effect of the glass fiber board 121 is enhanced, and a synergistic toughening capability inside the glass fiber board 121 is increased, thereby improving the puncture resistance of the glass fiber board 121. A puncture value of the glass fiber board 121 is between 100 N and 120 N. Compared with the existing glass fiber board, the puncture resistance of the glass fiber board 121 shown in this implementation may be improved by at least 21%.

In the electronic device 1000 shown in this embodiment of this application, the glass fiber board 121 of the back cover 120 has good puncture resistance. Therefore, the back cover 120 also has good puncture resistance. In addition, compared with an existing back cover made of plastic, the back cover 120 shown in this application is made of the glass fiber board 121, which helps improve strength of the back cover 120, ensures reliability of use of the back cover 120, and further ensures reliability of use of the electronic device 1000.

Refer to FIG. 16. FIG. 16 is a process flowchart of a first preparation method for a glass fiber board according to an embodiment of this application.

The preparation method for a glass fiber board in this embodiment is used for preparing the glass fiber board 121 shown in the first implementation described above. The preparation method for a glass fiber board includes step S1 to step S3.

Step S1: Provide a plurality of glass fiber layers 10. As shown in FIG. 5, each glass fiber layer 10 includes a plurality of first fibers 11 and a plurality of second fibers 12. The plurality of first fibers 11 and the plurality of second fibers 12 form the glass fiber layer 10 through a weaving process. Both the first fibers 11 and the second fibers 12 are glass fibers. For example, grammage of the glass fiber layer 10 is greater than or equal to 100 g/m². In some other embodiments, the grammage of the glass fiber layer 10 may alternatively be less than 100 g/m².

Each glass fiber layer 10 has a first direction D₁ and a second direction D₂. The plurality of first fibers 11 extend along the first direction D₁ and are arranged at intervals with each other along the second direction D₂. The plurality of second fibers 12 extend along the second direction D₂ and are arranged at intervals with each other along the first direction D₁. For example, the first direction D₁ and the second direction D₂ are perpendicular to each other. In some other embodiments, the first direction D₁ and the second direction D₂ may not be perpendicular to each other.

It should be noted that the glass fiber layers 10 described in this embodiment of this application are all glass fiber layers on which a resin impregnation process is performed. A resin system and a resin content that are used in the resin impregnation process are not specifically limited in this embodiment of this application.

Step S2: Stack the plurality of glass fiber layers 10. Specifically, at least two glass fiber layers 10 are helically stacked in a staggering manner. In this embodiment, a helical staggering angle between at least two types of glass fiber layers 10 is greater than 0 degrees and less than 90 degrees, or is greater than 90 degrees and less than 180 degrees. Specifically, a helical staggering angle between any two glass fiber layers 10 is greater than 0 degrees and less than 180 degrees. A helical staggering angle between two adjacent glass fiber layers 10 is greater than 0 degrees and less than or equal to 45 degrees. In some other implementations, the helical staggering angle between any two glass fiber layers 10 may be greater than 0 degrees and less than 90 degrees, or the helical staggering angle between any two glass fiber layers 10 may be greater than 0 degrees and less than or equal to 45 degrees.

The plurality of glass fiber layers 10 include the first glass fiber layer 10a (as shown in FIG. 6), the second glass fiber layer 10b (as shown in FIG. 7), the third glass fiber layer 10c (as shown in FIG. 8), and the fourth glass fiber layer 10d (as shown in FIG. 9). The helical staggering angle between the second glass fiber layer 10b and the first glass fiber layer 10a is β-α, the helical staggering angle between the third glass fiber layer 10c and the second glass fiber layer 10b is γ-β, and the helical staggering angle between the fourth glass fiber layer 10d and the third glass fiber layer 10c is δ-γ.

For example, the helical staggering angle between adjacent glass fiber layers 10 is 20 degrees. For example, α=20 degrees, β=40 degrees, γ=60 degrees, and δ=80 degrees. In other words, before the first glass fiber layer 10a, the second glass fiber layer 10b, the third glass fiber layer 10c, and the fourth glass fiber layer 10d are stacked, the first glass fiber layer 10a is rotated by 20 degrees, the second glass fiber layer 10b is rotated by 40 degrees, the third glass fiber layer 10c is rotated by 60 degrees, the fourth glass fiber layer 10d is rotated by 80 degrees, and subsequently, the first glass fiber layer 10a, the second glass fiber layer 10b, the third glass fiber layer 10c, and the fourth glass fiber layer 10d are sequentially stacked.

In some other embodiments, the helical staggering angle between adjacent glass fiber layers 10 may alternatively be 30 degrees. Before the first glass fiber layer 10a, the second glass fiber layer 10b, the third glass fiber layer 10c, and the fourth glass fiber layer 10d are stacked, the first glass fiber layer 10a may be rotated by 30 degrees, the second glass fiber layer 10b may be rotated by 60 degrees, the third glass fiber layer 10c may be rotated by 90 degrees, and the fourth glass fiber layer 10d may be rotated by 120 degrees, or the first glass fiber layer 10a may be rotated by 45 degrees, the second glass fiber layer 10b may be rotated by 90 degrees, the third glass fiber layer 10c may be rotated by 135 degrees, and the fourth glass fiber layer 10d may be rotated by 180 degrees, and subsequently, the first glass fiber layer 10a, the second glass fiber layer 10b, the third glass fiber layer 10c, and the fourth glass fiber layer 10d are sequentially stacked.

Step S3: Laminate the plurality of stacked glass fiber layers 10, to obtain the glass fiber board 121, as shown in FIG. 4. Specifically, the plurality of stacked glass fiber layers 10 are laminated by using a vacuum hot pressing tank process, to obtain the glass fiber board 121. A heat pressing temperature is about 120 degrees Celsius, a pressure is 1 MPa, and a curing time is between 60 minutes and 90 minutes.

An embodiment of this application further provides a second preparation method for a glass fiber board. The second preparation method for a glass fiber board is used for preparing the glass fiber board 121 shown in the second implementation described above.

The preparation method for a glass fiber board in this embodiment includes step S1 to step S3.

Step S1: Provide a plurality of glass fiber layers 10. As shown in FIG. 12, each glass fiber layer 10 includes a plurality of first fibers 11 and a plurality of second fibers 12. The plurality of first fibers 11 and the plurality of second fibers 12 form the glass fiber layer 10 through a weaving process. Each glass fiber layer 10 has a first direction D₁ and a second direction D₂. For example, the first direction D₁ is parallel to an X-axis direction, and the second direction D₂ is parallel to a Y-axis direction. The plurality of first fibers 11 extend along the first direction D₁ and are arranged at intervals with each other along the second direction D₂.

In this implementation, the plurality of glass fiber layers 10 include one or more composite glass fiber layers. Specifically, the plurality of glass fiber layers 10 are all composite glass fiber layers. In each composite glass fiber layer 10, the plurality of first fibers 11 are all glass fibers. The plurality of second fibers 12 include a plurality of third fibers 13 and a plurality of fourth fibers 14. The plurality of fourth fibers 14 are all glass fibers. Toughness of the third fiber 13 is greater than toughness of the glass fiber, and strength of the third fiber 13 is greater than strength of the glass fiber. For example, the third fiber 13 is an aramid fiber or a carbon fiber.

The plurality of third fibers 13 are arranged at uniform intervals along the first direction D₁, to ensure uniformity of toughness and strength of the glass fiber layer 10, and ensure uniformity of puncture resistance of the glass fiber layer 10, thereby ensuring uniformity of puncture resistance of the glass fiber board 121. For example, the plurality of third fibers 13 and the plurality of fourth fibers 14 are arranged alternately along the first direction D₁. In some other implementations, the plurality of third fibers 13 may alternatively be arranged at non-uniform intervals along the first direction D₁, or the plurality of second fibers 12 may alternatively include only one third fiber 13, or the plurality of second fibers 12 may be all fourth fibers 14.

In some other implementations, the plurality of first fibers 11 may alternatively include a plurality of fifth fibers and one or more sixth fibers. The sixth fiber is a glass fiber. Toughness of the fifth fiber is greater than the toughness of the glass fiber, and strength of the fifth fiber is greater than the strength of the glass fiber. For example, the sixth fiber is an aramid fiber or a carbon fiber. In this case, the plurality of fifth fibers are arranged at uniform intervals along the second direction D₂. Alternatively, the plurality of first fibers 11 may include one fifth fiber, or the plurality of first fibers 11 may be all fifth fibers.

In this embodiment, step S1 includes step S11 to step S13.

Step S11: Provide a fiber cloth. The fiber cloth includes a plurality of radial fibers and a plurality of zonal fibers. The plurality of zonal fibers and the plurality of radial fibers form the fiber cloth through a weaving process. The plurality of zonal fibers are all glass fibers. The plurality of radial fibers includes a plurality of first-type fibers and a plurality of second-type fibers. The plurality of second-type fibers are all glass fibers. Toughness and strength of the first-type fiber are both greater than those of the second-type fiber. For example, the first-type fiber is an aramid fiber or a carbon fiber. It should be noted that the thicknesses of the glass fiber, the aramid fiber, and the carbon fiber in the fiber cloth shown in this embodiment of this application are not specifically limited, and the fiber cloth may only be formed through the weaving process.

Step S12: Perform resin impregnation processing on the fiber cloth. Specifically, the fiber cloth is impregnated with epoxy resin. A resin content is about 50%, and the thickness of the impregnated fiber cloth is about 0.1 mm. In some other embodiments, another type of resin may be used to impregnate the fiber cloth, and/or resin of another content may be used to impregnate the fiber cloth. A resin type, a resin content, and the thickness of the fiber cloth are not specifically limited in this embodiment of this application.

Step S13: Dry and wrap the impregnated fiber cloth, and then cut the impregnated fiber cloth into a plurality of glass fiber layers 10. Specifically, the plurality of zonal fibers of the fiber cloth form the plurality of first fibers 11 of the glass fiber layer 10, and the plurality of radial fibers of the fiber cloth form the plurality of second fibers 12 of the glass fiber layer 10. The plurality of first-type fibers of the fiber cloth form the plurality of third fibers 13 of the glass fiber layer 10, and the plurality of second-type fibers of the fiber cloth form the plurality of fourth fibers of the glass fiber layer 10.

Step S2: Stack the plurality of glass fiber layers 10. Specifically, the plurality of glass fiber layers 10 are directly stacked. A helical staggering angle between any two glass fiber layers 10 is 0 degrees.

Step S3: Laminate the plurality of stacked glass fiber layers 10, to obtain the glass fiber board 121, as shown in FIG. 11. Specifically, the plurality of stacked glass fiber layers 10 are laminated by using a vacuum hot pressing tank process, to obtain the glass fiber board 121. A heat pressing temperature is about 120 degrees Celsius, a pressure is 1 MPa, and a curing time is between 60 minutes and 90 minutes.

An embodiment of this application further provides a third preparation method for a glass fiber board. The third preparation method for a glass fiber board is used for preparing the glass fiber board 121 shown in the fourth implementation described above.

The preparation method for a glass fiber board in this embodiment includes step S1 to step S3.

Step S1: Provide a plurality of glass fiber layers 10. It should be noted that step S1 in this embodiment is the same as step S1 in the second preparation method for a glass fiber board, and details are not described herein again.

Step S2: Stack the plurality of glass fiber layers 10. Specifically, at least two glass fiber layers 10 are helically stacked in a staggering manner. In this embodiment, a helical staggering angle between at least two types of glass fiber layers 10 is greater than 0 degrees and less than 90 degrees, or is greater than 90 degrees and less than 180 degrees. Specifically, a helical staggering angle between any two glass fiber layers 10 is greater than 0 degrees and less than 180 degrees. A helical staggering angle between two adjacent glass fiber layers 10 is greater than 0 degrees and less than or equal to 45 degrees. It should be noted that step S2 in this embodiment is the same as step S2 in the first preparation method for a glass fiber board, and details are not described herein again.

Step S3: Laminate the plurality of stacked glass fiber layers 10, to obtain the glass fiber board 121, as shown in FIG. 15. Specifically, the plurality of stacked glass fiber layers 10 are laminated by using a vacuum hot pressing tank process, to obtain the glass fiber board 121. A heat pressing temperature is about 120 degrees Celsius, a pressure is 1 MPa, and a curing time is between 60 minutes and 90 minutes.

The foregoing descriptions are merely specific implementations of this application, but the protection scope of this application is not limited thereto. Any variation or replacement readily figured out by a person skilled in the art within the technical scope disclosed in this application shall fall within the protection scope of this application. The embodiments of this application and features in the embodiments may be combined with each other when no conflict occurs. Therefore, the protection scope of this application shall be subject to the protection scope of the claims.

## Claims

1. A glass fiber board (121), comprising a plurality of glass fiber layers (10) disposed in a stacking manner, wherein each glass fiber layer comprises a plurality of first fibers (11) and a plurality of second fibers (12), the plurality of first fibers (11) and the plurality of second fibers (12) are disposed in an interlacing manner, each glass fiber layer has a first direction and a second direction, the plurality of first fibers (11) extend along the first direction of the glass fiber layer and are arranged at intervals along the second direction of the glass fiber layer, the plurality of second fibers (12) extend along the second direction of the glass fiber layer and are arranged at intervals along the first direction of the glass fiber layer, the plurality of glass fiber layers comprise one or more composite glass fiber layers, the plurality of second fibers (12) in each composite glass fiber layer comprise one or more third fibers (13), and toughness of the third fiber (13) is greater than toughness of a glass fiber, and a helical staggering angle between at least two glass fiber layers (10) is greater than 0 degrees and less than 90 degrees or is greater than 90 degrees and less than 180 degrees, wherein
a helical staggering angle between two glass fiber layers (10) is an included angle between the first directions of the two glass fiber layers (10), or a helical staggering angle between two glass fiber layers (10) is an included angle between the second directions of the two glass fiber layers (10).

2. The glass fiber board (121) according to claim 1, wherein a helical staggering angle between any two glass fiber layers (10) is greater than 0 degrees and less than 180 degrees, or greater than 0 degrees and less than 90 degrees, or greater than 0 degrees and less than or equal to 45 degrees.

3. The glass fiber board (121) according to claim 2, wherein a helical staggering angle between two adjacent glass fiber layers (10) is greater than 0 degrees and less than or equal to 45 degrees.

4. The glass fiber board (121) according to any one of claims 1 to 3, wherein in each glass fiber layer, both the plurality of first fibers (11) and the plurality of second fibers (12) are glass fibers.

5. The glass fiber board (121) according to any one of claims 1, wherein the strength of the third fiber is greater than strength of the glass fiber.

6. The glass fiber board (121) according to claim 1 or claim 5, wherein there are a plurality of third fibers, and the plurality of third fibers are arranged at uniform intervals along a first direction of the composite glass fiber layer; and the third fiber is an aramid fiber or a carbon fiber.

7. The glass fiber board (121) according to claim 1 or 5 or 6, wherein in each composite glass fiber layer, the plurality of second fibers (12) further comprise one or more fourth fibers, and the fourth fiber is a glass fiber, and
there are a plurality of third fibers and a plurality of fourth fibers, and the plurality of third fibers and the plurality of fourth fibers are alternately arranged along the first direction of the composite glass fiber layer.

8. The glass fiber board (121) according to claim 1 or 5 to 7, wherein in each composite glass fiber layer, each second fiber is the third fiber.

9. The glass fiber board (121) according to any one of claims 1 or 5 to 8, wherein in each composite glass fiber layer, the plurality of first fibers (11) are all glass fibers.

10. The glass fiber board (121) according to any one of claims 1 or 5 to 8, wherein in each composite glass fiber layer, the plurality of first fibers (11) comprise one or more fifth fibers, and toughness of the fifth fiber is greater than the toughness of the glass fiber.

11. The glass fiber board (121) according to any one of claims 1 or 5 to 10, wherein each glass fiber layer is the composite glass fiber layer.

12. A glass fiber board (121), comprising a plurality of glass fiber layers (10) that are disposed in a stacking manner, wherein each glass fiber layer comprises a plurality of first fibers (11) and a plurality of second fibers (12), each glass fiber layer has a first direction and a second direction, the plurality of first fibers (11) extend along the first direction of the glass fiber layer and are arranged at intervals along the second direction of the glass fiber layer, and the plurality of second fibers (12) extend along the second direction of the glass fiber layer and are arranged at intervals along the first direction of the glass fiber layer; and
the plurality of glass fiber layers (10) comprise one or more composite glass fiber layers (10), the plurality of second fibers (12) in each composite glass fiber layer comprise one or more third fibers (13), and toughness of the third fiber is greater than toughness of a glass fiber.

13. The glass fiber board (121) according to claim 12, wherein a helical staggering angle between any two glass fiber layers (10) is 0 degrees.

14. A back cover, comprising the glass fiber board (121) according to any one of claims 1 to 13 and a decorative layer, wherein the decorative layer is disposed on a bottom surface of the glass fiber board (121).

15. An electronic device, comprising the back cover according to claim 14 and a frame, wherein the back cover is mounted on one side of the frame.

## Patentansprüche

1. Glasfaserplatte (121), umfassend eine Vielzahl von Glasfaserschichten (10), die in einer gestapelten Weise angeordnet sind, wobei jede Glasfaserschicht eine Vielzahl von ersten Fasern (11) und eine Vielzahl von zweiten Fasern (12) umfasst, wobei die Vielzahl der ersten Fasern (11) und die Vielzahl der zweiten Fasern (12) in einer verflochtenen Weise angeordnet sind, wobei jede Glasfaserschicht eine erste Richtung und eine zweite Richtung aufweist, wobei die Vielzahl der ersten Fasern (11) sich entlang der ersten Richtung der Glasfaserschicht erstreckt und in Abständen entlang der zweiten Richtung der Glasfaserschicht angeordnet ist, wobei die Vielzahl der zweiten Fasern (12) sich entlang der zweiten Richtung der Glasfaserschicht erstreckt und in Abständen entlang der ersten Richtung der Glasfaserschicht angeordnet ist, wobei die Vielzahl der Glasfaserschichten eine oder mehrere Verbundglasfaserschichten umfasst, wobei die Vielzahl der zweiten Fasern (12) in jeder Verbundglasfaserschicht eine oder mehrere dritte Fasern (13) umfasst, und wobei die Zähigkeit der dritten Faser (13) größer ist als die Zähigkeit einer Glasfaser, und wobei ein spiralförmiger Versatzwinkel zwischen mindestens zwei Glasfaserschichten (10) größer als 0 Grad und kleiner als 90 Grad ist oder größer als 90 Grad und kleiner als 180 Grad ist, wobei
ein spiralförmiger Versatzwinkel zwischen zwei Glasfaserschichten (10) ein eingeschlossener Winkel zwischen den ersten Richtungen der beiden Glasfaserschichten (10) ist, oder ein spiralförmiger Versatzwinkel zwischen zwei Glasfaserschichten (10) ein eingeschlossener Winkel zwischen den zweiten Richtungen der beiden Glasfaserschichten (10) ist.

2. Glasfaserplatte (121) nach Anspruch 1, wobei ein spiralförmiger Versatzwinkel zwischen zwei beliebigen Glasfaserschichten (10) größer als 0 Grad und kleiner als 180 Grad ist, oder größer als 0 Grad und kleiner als 90 Grad ist, oder größer als 0 Grad und kleiner oder gleich 45 Grad ist.

3. Glasfaserplatte (121) nach Anspruch 2, wobei ein spiralförmiger Versatzwinkel zwischen zwei benachbarten Glasfaserschichten (10) größer als 0 Grad und kleiner oder gleich 45 Grad ist.

4. Glasfaserplatte (121) nach einem der Ansprüche 1 bis 3, wobei in jeder Glasfaserschicht sowohl die Vielzahl der ersten Fasern (11) als auch die Vielzahl der zweiten Fasern (12) Glasfasern sind.

5. Glasfaserplatte (121) nach Anspruch 1, wobei die Festigkeit der dritten Faser größer ist als die Festigkeit der Glasfaser.

6. Glasfaserplatte (121) nach Anspruch 1 oder Anspruch 5, wobei eine Vielzahl von dritten Fasern vorhanden ist und die Vielzahl der dritten Fasern in gleichmäßigen Abständen entlang einer ersten Richtung der Verbundglasfaserschicht angeordnet ist; und wobei die dritte Faser eine Aramidfaser oder eine Kohlenstofffaser ist.

7. Glasfaserplatte (121) nach Anspruch 1 oder 5 oder 6, wobei in jeder Verbundglasfaserschicht die Vielzahl der zweiten Fasern (12) ferner eine oder mehrere vierte Fasern umfasst und die vierte Faser eine Glasfaser ist und
eine Vielzahl von dritten Fasern und eine Vielzahl von vierten Fasern vorhanden sind und die Vielzahl der dritten Fasern und die Vielzahl der vierten Fasern abwechselnd entlang der ersten Richtung der Verbundglasfaserschicht angeordnet sind.

8. Glasfaserplatte (121) nach Anspruch 1 oder 5 bis 7, wobei in jeder Verbundglasfaserschicht jede zweite Faser die dritte Faser ist.

9. Glasfaserplatte (121) nach einem der Ansprüche 1 oder 5 bis 8, wobei in jeder Verbundglasfaserschicht die Vielzahl der ersten Fasern (11) allesamt Glasfasern sind.

10. Glasfaserplatte (121) nach einem der Ansprüche 1 oder 5 bis 8, wobei in jeder Verbundglasfaserschicht die Vielzahl der ersten Fasern (11) eine oder mehrere fünfte Fasern umfasst und die Zähigkeit der fünften Faser größer ist als die Zähigkeit der Glasfaser.

11. Glasfaserplatte (121) nach einem der Ansprüche 1 oder 5 bis 10, wobei jede Glasfaserschicht die Verbundglasfaserschicht ist.

12. Glasfaserplatte (121), umfassend eine Vielzahl von Glasfaserschichten (10), die in einer stapelartigen Weise angeordnet sind, wobei jede Glasfaserschicht eine Vielzahl von ersten Fasern (11) und eine Vielzahl von zweiten Fasern (12) umfasst, wobei jede Glasfaserschicht eine erste Richtung und eine zweite Richtung aufweist, wobei sich die Vielzahl der ersten Fasern (11) entlang der ersten Richtung der Glasfaserschicht erstreckt und in Abständen entlang der zweiten Richtung der Glasfaserschicht angeordnet ist, und wobei sich die Vielzahl der zweiten Fasern (12) entlang der zweiten Richtung der Glasfaserschicht erstreckt und in Abständen entlang der ersten Richtung der Glasfaserschicht angeordnet ist; und
die Vielzahl der Glasfaserschichten (10) eine oder mehrere Verbundglasfaserschichten (10) umfasst, wobei die Vielzahl der zweiten Fasern (12) in jeder Verbundglasfaserschicht eine oder mehrere dritte Fasern (13) umfasst und die Zähigkeit der dritten Faser größer ist als die Zähigkeit einer Glasfaser.

13. Glasfaserplatte (121) nach Anspruch 12, wobei ein spiralförmiger Versatzwinkel zwischen zwei beliebigen Glasfaserschichten (10) 0 Grad beträgt.

14. Rückseitige Abdeckung, umfassend die Glasfaserplatte (121) nach einem der Ansprüche 1 bis 13 und eine dekorative Schicht, wobei die dekorative Schicht auf einer Unterseite der Glasfaserplatte (121) angeordnet ist.

15. Elektronische Vorrichtung, umfassend die rückseitige Abdeckung nach Anspruch 14 und einen Rahmen, wobei die rückseitige Abdeckung auf einer Seite des Rahmens montiert ist.

## Revendications

1. Panneau de fibres de verre (121), comprenant une pluralité de couches de fibres de verre (10) disposées en empilement, dans lequel chaque couche de fibres de verre comprend une pluralité de premières fibres (11) et une pluralité de secondes fibres (12), la pluralité de premières fibres (11) et la pluralité de secondes fibres (12) sont disposées de manière entrelacée, chaque couche de fibres de verre a une première direction et une seconde direction, la pluralité de premières fibres (11) s'étendent le long de la première direction de la couche de fibres de verre et sont agencées à intervalles le long de la seconde direction de la couche de fibres de verre, la pluralité de secondes fibres (12) s'étendent le long de la seconde direction de la couche de fibres de verre et sont agencées à intervalles le long de la première direction de la couche de fibres de verre, la pluralité de couches de fibres de verre comprennent une ou plusieurs couches de fibres de verre composites, la pluralité de secondes fibres (12) dans chaque couche de fibres de verre composite comprennent une ou plusieurs troisièmes fibres (13), et la ténacité de la troisième fibre (13) est supérieure à la ténacité d'une fibre de verre, et un angle de décalage hélicoïdal entre au moins deux couches de fibres de verre (10) est supérieur à 0 degré et inférieur à 90 degrés ou est supérieur à 90 degrés et inférieur à 180 degrés, dans lequel
un angle de décalage hélicoïdal entre deux couches de fibres de verre (10) est un angle inclus entre les premières directions des deux couches de fibres de verre (10), ou un angle de décalage hélicoïdal entre deux couches de fibres de verre (10) est un angle inclus entre les secondes directions des deux couches de fibres de verre (10).

2. Panneau de fibres de verre (121) selon la revendication 1, dans lequel un angle de décalage hélicoïdal entre deux couches de fibres de verre (10) quelconques est supérieur à 0 degré et inférieur à 180 degrés, ou supérieur à 0 degré et inférieur à 90 degrés, ou supérieur à 0 degré et inférieur ou égal à 45 degrés.

3. Panneau de fibres de verre (121) selon la revendication 2, dans lequel un angle de décalage hélicoïdal entre deux couches de fibres de verre (10) adjacentes est supérieur à 0 degré et inférieur ou égal à 45 degrés.

4. Panneau de fibres de verre (121) selon l'une quelconque des revendications 1 à 3, dans lequel, dans chaque couche de fibres de verre, à la fois la pluralité de premières fibres (11) et la pluralité de secondes fibres (12) sont des fibres de verre.

5. Panneau de fibres de verre (121) selon la revendication 1, dans lequel la résistance de la troisième fibre est supérieure à la résistance de la fibre de verre.

6. Panneau de fibres de verre (121) selon la revendication 1 ou la revendication 5, dans lequel il existe une pluralité de troisièmes fibres, et la pluralité de troisièmes fibres sont agencées à intervalles uniformes le long d'une première direction de la couche de fibres de verre composite ; et la troisième fibre est une fibre d'aramide ou une fibre de carbone.

7. Panneau de fibres de verre (121) selon la revendication 1 ou 5 ou 6, dans lequel, dans chaque couche de fibres de verre composite, la pluralité de secondes fibres (12) comprennent en outre une ou plusieurs quatrièmes fibres, et la quatrième fibre est une fibre de verre, et
il existe une pluralité de troisièmes fibres et une pluralité de quatrièmes fibres, et la pluralité de troisièmes fibres et la pluralité de quatrièmes fibres sont disposées de manière alternée le long de la première direction de la couche de fibres de verre composite.

8. Panneau de fibres de verre (121) selon la revendication 1 ou 5 à 7, dans lequel, dans chaque couche de fibres de verre composite, chaque seconde fibre est la troisième fibre.

9. Panneau de fibres de verre (121) selon l'une quelconque des revendications 1 ou 5 à 8, dans lequel, dans chaque couche de fibres de verre composite, la pluralité de premières fibres (11) sont toutes des fibres de verre.

10. Panneau de fibres de verre (121) selon l'une quelconque des revendications 1 ou 5 à 8, dans lequel, dans chaque couche de fibres de verre composite, la pluralité de premières fibres (11) comprennent une ou plusieurs cinquièmes fibres, et la ténacité de la cinquième fibre est supérieure à la ténacité de la fibre de verre.

11. Panneau de fibres de verre (121) selon l'une quelconque des revendications 1 ou 5 à 10, dans lequel chaque couche de fibres de verre est la couche de fibres de verre composite.

12. Panneau de fibres de verre (121), comprenant une pluralité de couches de fibres de verre (10) qui sont disposées de manière empilée, dans lequel chaque couche de fibres de verre comprend une pluralité de premières fibres (11) et une pluralité de secondes fibres (12), chaque couche de fibres de verre a une première direction et une seconde direction, la pluralité de premières fibres (11) s'étendent le long de la première direction de la couche de fibres de verre et sont disposées à intervalles le long de la seconde direction de la couche de fibres de verre, et la pluralité de secondes fibres (12) s'étendent le long de la seconde direction de la couche de fibres de verre et sont disposées à intervalles le long de la première direction de la couche de fibres de verre ; et
la pluralité de couches de fibres de verre (10) comprennent une ou plusieurs couches de fibres de verre composites (10), la pluralité de secondes fibres (12) dans chaque couche de fibres de verre composite comprennent une ou plusieurs troisièmes fibres (13), et la ténacité de la troisième fibre est supérieure à la ténacité d'une fibre de verre.

13. Panneau de fibres de verre (121) selon la revendication 12, dans lequel un angle de décalage hélicoïdal entre deux couches de fibres de verre (10) quelconques est de 0 degré.

14. Couvercle arrière, comprenant le panneau de fibres de verre (121) selon l'une quelconque des revendications 1 à 13 et une couche décorative, dans lequel la couche décorative est disposée sur une surface inférieure du panneau de fibres de verre (121).

15. Dispositif électronique, comprenant le couvercle arrière selon la revendication 14 et un cadre, dans lequel le couvercle arrière est monté sur un côté du cadre.
